(19) **Europäisches Patentamt / European Patent Office / Office européen des brevets**

(11) **EP 4 416 753 B1**

(12) **EUROPEAN PATENT SPECIFICATION**

(45) Date of publication and mention
of the grant of the patent:
**19.02.2025 Bulletin 2025/08**

(21) Application number: **21819717.6**

(22) Date of filing: **15.10.2021**

(51) International Patent Classification (IPC):
*H01J 37/32* (2006.01)

(52) Cooperative Patent Classification (CPC):
**H01J 37/32917; H01J 37/32568; H01J 37/32577; H01J 37/32935**

(86) International application number:
**PCT/CZ2021/050113**

(87) International publication number:
**WO 2023/061519 (20.04.2023 Gazette 2023/16)**

(54) **METHOD AND SYSTEM FOR PLASMA DIAGNOSTICS**

VERFAHREN UND SYSTEM ZUR PLASMADIAGNOSTIK

MÉTHODE ET SYSTÈME DE DIAGNOSTIC D'UN PLASMA

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.08.2024 Bulletin 2024/34**

(73) Proprietors:
• **Univerzita Palackého v Olomouci**
  **779 00 Olomouc (CZ)**
• **Fyzikální ústav AV CR, v.v.i.**
  **18221 Praha 8 (CZ)**

(72) Inventors:
• **HRABOVSKÝ, Miroslav**
  **77900 Olomouc (CZ)**
• **HUBICKA, Zdenek**
  **15200 Praha (CZ)**
• **HRUBANTOVÁ, Aneta**
  **12000 Praha (CZ)**
• **SCHOVÁNEK, Petr**
  **75131 Lipník nad Becvou (CZ)**
• **CTVRTLÍK, Radim**
  **78316 Belkovice-Last'any (CZ)**
• **CADA, Martin**
  **19800 Praha (CZ)**
• **OLEJNÍCEK, Jirí**
  **25068 Husinec - Rez (CZ)**
• **KSÍROVÁ, Petra**
  **47101 Zahrádky (CZ)**

• **DVORÁKOVÁ, Michaela**
  **18200 Praha (CZ)**
• **STRANÁK, Vítezslav**
  **37005 Ceské Budejovice (CZ)**

(74) Representative: **Tomickova, Dana**
  **PatentEnter s.r.o.**
  **Koliste 1965/13a**
  **602 00 Brno (CZ)**

(56) References cited:
**WO-A1-2021/206609      CZ-U1- 31 194**

• **SEZEMSKY PETR ET AL: "Modified high frequency probe approach for diagnostics of highly reactive plasma", PLASMA SOURCES SCIENCE AND TECHNOLOGY, vol. 28, no. 11, 1 November 2019 (2019-11-01), GB, pages 115009, XP055938244, ISSN: 0963-0252, Retrieved from the Internet <URL:https://iopscience.iop. org/article/10.1088/1361-6595/ab506c> DOI: 10.1088/1361-6595/ab506c**
• **SOBOLEWSKI MARK A.: "Experimental test of models of high-plasma-density, radio-frequency sheaths", PHYSICAL REVIEW E. STATISTICAL PHYSICS, PLASMAS, FLUIDS, AND RELATED INTERDISCIPLINARY TOPICS., vol. 59, no. 1, 1 January 1999 (1999-01-01), US, pages 1059 - 1072, XP055938241, ISSN: 1063-651X, DOI: 10.1103/PhysRevE.59.1059**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 416 753 B1

**(Cont. next page)**

• LUNDIN DANIEL ET AL: "Time-resolved ion flux and impedance measurements for process characterization in reactive high-power impulse magnetron sputtering", JOURNAL OF VACUUM SCIENCE, AMERICAN INSTITUTE OF PHYSICS, 2 HUNTINGTON QUADRANGLE, MELVILLE, NY 11747, vol. 34, no. 4, 6 June 2016 (2016-06-06), XP012208220, ISSN: 0734-2101, [retrieved on 19010101], DOI: 10.1116/1.4953033

**Description**

Field of technology

Plasma technologies of thin film deposition, high-frequency discharges, plasma surface treatment, plasma etching, plasma diagnostics.

Prior Art

Low temperature plasma is widely used for PVD and PECVD thin film deposition, plasma etching, plasma activation and surface modification. For this purpose, an electrically conductive electrode is often inserted into the plasma, to which a high frequency (RF) voltage $U_{RFi}$ is applied. It is known that major part of this voltage is concentrated on the positive space charge sheath occurring at the surface of this electrode due to the interaction with the plasma. Then, a direct (DC) voltage $U_{bi}$ is generated on this charge sheath, the magnitude of which is given by a known relation (u1), where this relation is described and derived, for example, in the article: M.A. Liberman, A.J. Lichtenberg, Principles of Plasma Discharges and Materials Processing, Wiley, New York 1994:

$$(u1) \qquad \boldsymbol{U_{bi}} = \frac{\boldsymbol{k_B T_e}}{\boldsymbol{e}} \left( ln \sqrt{\frac{2M_i}{\pi m_e}} + ln\, I_0 \left( \frac{eU_{RFi}}{kT_e} \right) \right)$$

where $k_B$ is the Boltzmann constant, $T_e$ is electron temperature, e is the charge of the electron, $m_e$ is the mass of the electron, $M_i$ is the mass of the ions and $I_0$ is the Bessel function. Thus, a clear relation between $U_{bi}$ and $U_{RFI}$ under given plasma conditions is given. Thanks to the knowledge of $U_{RFi}$, it is therefore possible to clearly determine $U_{bi}$. Knowledge of $U_{bi}$ is important because the magnitude of this voltage determines the energy of positive ions bombarding the electrode surface from the quasineutral plasma region. These phenomena of ions bombarding the surface of RF electrode are described, for example, in the article: Mark A. Sobolewski, Monitoring sheath voltages and ion energies in high-density plasmas using noninvasive radio-frequency current and voltage measurements, Journal of Applied Physics 95, 4593 (2004). The accelerating DC voltage generated by the RF voltage on the space charge wall sheath in the plasma is also widely used for RF sputtering of thin films, as described, for example, in J. L. Vossen, RF SPUTTERING APPARATUS AND METHOD, US 3,860,507 (1975). Furthermore, this method is used for plasma ion etching, where reactive ions are accelerated on the RF electrode by generated DC bias, which etch off the electrode material, as described, for example, in D.L. Flamm, Solid State Technol. 34, 47 (1991). Another great advantage of using a RF voltage to generate a DC bias accelerating positive ions is the ability to apply the RF voltage to the space charge wall sheath through a thick dielectric through its capacity. Thus, stable ion bombardment also of the surface of these dielectrics can be achieved without charging its surface during RF reactive sputtering of fully dielectric and thus electrically non-conductive targets, as described, for example, in the patent U.S. Pat. No. 3,369,991.

Dielectric substrates are used in a similar configuration also for RF reactive plasma ion etching in RF capacitive discharges, as described, for example, in the application *US 2004/0014327 A1.*

An important part of this issue is the use of knowledge of waveforms of RF currents and voltages at this electrode to characterize plasma processes on the electrode surface. One is the knowledge of the DC accelerating voltage obtained from the RF voltage according to the relation (u1) or the DC bias is directly measured in the case of an electrically conductive electrode surface which interacts with the plasma. Another parameter that can be obtained from the knowledge of these waveforms of RF voltages and currents on the space charge sheath at the electrode surface is the ion flux. This methodology is described, for example, in: Mark A. Sobolewski, Measuring the ion current in high-density plasmas using radio-frequency current and voltage measurements, Journal of Applied Physics 90, 2660 (2001). Furthermore, it is possible to obtain from these RF signals parameters such as the electron temperature of plasma $T_e$, the concentration of ions $n_i$, as described in the article: Mark A. Sobolewski, Experimental test of models of high-plasma-density, radio-frequency sheaths, PHYSICAL REVIEW E, 59 (1999) 1059-1072 and further in the article: P. Sezemsky, V. Stranak, J. Kratochvil, M. Cada, R. Hippler, M. Hrabovsky, Z. Hubicka, Modified high frequency probe approach for diagnostics of highly reactive plasma, Plasma Sources Sci. Technol. 28 (2019) 115009 (10pp). LUNDIN DANIEL ET AL: "Time-resolved ion flux and impedance measurements for process characterization in reactive high-power impulse magnetron sputtering", JOURNAL OF VACUUM SCIENCE, vol. 34, no. 4, 6 June 2016 discloses a new planar ion flux probe, based on the Sobolewski method, for time-resolved plasma characterization in inherently noisy pulsed plasma discharges. CZ31194 U1 discloses an impedance spectrograph for impedance measurement of a deposited layer in a discharge plasma.

The methods described in these articles have the advantage that they work reliably even when the conductive RF electrode is covered with a dielectric layer. However, the limiting condition is that this dielectric layer must be so thin that the RF voltage drop that occurs thereon by the passage of the RF current is negligible compared to the RF voltage drop on the space charge wall sheath in the plasma. However, if the dielectric layer is thick and capacity, dielectric constant or surface area thereof is not known, it is not possible to determine the RF voltage drop across the space charge sheath at the surface of this thick dielectric.

SUMMARY OF THE INVENTION

The above-mentioned disadvantages of the prior art are at least partially solved by a method of plasma diagnostics, according to claim 1, in which an alternating voltage of frequency $f$ in the range of values of 0.01-100 MHz is applied to a reference electrode. The reference electrode has a measurable and well-defined area $A_{AP}$, it is located in a discharge chamber and in contact with the plasma excited in the discharge chamber. A first set of waveforms of electric current and voltage on the reference electrode corresponding to the current and voltage values measured on the electrode over a certain time interval is created, e.g., to obtain the time and volt-ampere characteristics of the reference probe. After the creation of the first set of values, the supply of voltage to the reference electrode is terminated. Subsequently, a second set of values is created, which is created from the first set of values by subtracting the parasitic current and voltage values, thereby obtaining the time and volt-ampere characteristics of the reference electrode without the influence of parasitic values. From the second set of values, the value of the differential conductivity $Y_{AP}$ and the differential capacity of the reference electrode in the region of the floating potential of the plasma is determined, or for values close to the value of the floating potential of the plasma with error 20%, e.g., by calculation of the tangent of dependence, direct calculation or direct measurement. In the next step, an alternating voltage of the same frequency is applied to the main electrode. The main electrode is also located in the discharge chamber and is in contact with the plasma. It is preferably designed as a planar electrode, e.g., rectangular or square. It is heterogeneously covered by a dielectric of an unknown dielectric constant, so it is not possible to accurately determine its surface and roughness by conventional measurement method. The roughness varies in different places, the thickness of the dielectric and its composition is not homogeneous. By measurement of RF voltage and current on the main electrode, a third set of waveforms of electric current and voltage on the main electrode over a certain time interval is created, e.g., in order to obtain time and volt-ampere characteristics of the main electrode. After the creation of the third set of values, the supply of voltage to the main electrode is terminated. Subsequently, a fourth set of values is created, which is formed from the third set of values by subtracting the parasitic values of current and voltage waveforms, thus obtaining the time and volt-ampere characteristics of the main electrode without the influence of undesired values.

From the fourth set of values, the value of the complex impedance $Z_{HP}$ of the main electrode is calculated according to the relation:

$$\hat{Z}_{HP} = \frac{\hat{U}_{HP}}{\hat{I}_{HP}}.$$

The conductivity $Y_{AP}$ and the capacity $C_{AP}$ are proportional to the ratio of the surfaces of the reference and main probe, i.e., $Y_{HP} = k * Y_{AP}$ and $C_{HP} = k * C_{AP}$, where $k = A_{HP} / A_{AP}$. However, to complete the calculation, it is necessary to know the surface of the main electrode. Using real and imaginary components of complex impedance

$$\mathrm{Re}Z_{HP} = \frac{Y_{AP}}{k \cdot (Y_{AP}^2 + \omega^2 C_{AP}^2)}$$

and

$$\mathrm{Im}Z_{HP} = \frac{-1}{\omega C_d} - \frac{\omega C_{AP}}{k(Y_{AP}^2 + \omega^2 C_{AP}^2)}$$

the coefficient of the area ratio can be determined as

$$k = \frac{Y_{AP}}{\mathrm{Re}Z_{HP}((Y_{AP}^2 + \omega^2 C_{AP}^2)},$$

where $\omega = 2\pi f$ is the angular frequency of the applied voltage. The advantage of this procedure is simple and accurate determination of the area of the main electrode, which can serve as a sample holder, the capacity of the dielectric with which the main electrode is covered, and subsequently other plasma parameters such as ion concentration, ion flux or electron temperature which are important parameters describing the behavior of this technical system and knowledge thereof is essential in the choice of experimental conditions, e.g., for deposition in the given discharge chamber.

Advantageously, thanks to the present diagnostic method, the capacity of the dielectric that covers the main electrode can be determined. Due to the fact that the composition of the dielectric is heterogenous similarly to its thickness and roughness, it is practically impossible to determine the capacity of this dielectric and its dielectric constant by direct measurement. With the above-mentioned procedure, it is possible to determine the capacitance of this dielectric as

$$C_d = \frac{-1}{\omega(\mathrm{Im}Z_{HP} + \frac{\omega C_{AP}}{k(Y_{AP}^2 + \omega^2 C_{AP}^2)})}.$$

Preferably, the operating frequency of the AC voltage is selected in the narrower range of 0.1-10 MHz, these values have the least effect on the plasma and allow a more accurate determination of parasitic currents and voltages of the main and reference electrodes. Preferably, the frequency of the alternating voltage is lower than the plasma frequency of the ions.

In a preferred embodiment, the parasitic current and voltage values of the reference and main electrodes are obtained by applying an alternating voltage of the above-used frequency to the reference electrode and measuring the time volt-ampere characteristic of the reference electrode in the absence of plasma.

Preferably, also with the aid of described plasma diagnostic method, the voltage of the wall sheath is calculated by measuring the current passing through the capacitor $C_d$ as

$$U_{\mathrm{cd}} = \frac{1}{C_{\mathrm{d}}} \int_0^t i_{\mathrm{HP}}\mathrm{d}t. \qquad \text{[relation (1)]}$$

The voltage on the wall sheath then has the value:

$$U_{\mathrm{shHP}} = U_{\mathrm{HP}} - U_{\mathrm{cd}}. \qquad \text{[relation (2)]}$$

Preferably, the presented method comprises an intermediate step, where after the end of the measurement, or. applying a voltage to the reference electrode, the reference electrode is covered by the reference electrode shielding mechanism. After the measurement is terminated, it is possible to remove or shield the reference electrode from other measurements and work only with the HP electrode also for other conditions and parameters in plasma and different frequencies of high-frequency voltage $U_{HP}$ on the HP probe, if the $C_d$ capacity does not change with this frequency.

The above-mentioned drawbacks of the prior art are further at least partially eliminated by a system for plasma diagnostics, according to claim 8, comprising a discharge chamber, a pump adapted to create and maintain low pressure in a discharge chamber, where low pressure means a pressure below atmospheric. The system further includes a plasma source, a harmonic generator, and at least one measuring device that allows monitoring of voltage and current values on the selected electrical circuit component. The system further includes a main electrode with surface covered with a dielectric. The main electrode is placed in the discharge chamber in contact with the plasma when it is excited. The dielectric covers the electrode heterogeneously both in thickness and roughness and in composition. Therefore, it is not possible in principle to determine the size of the area of the main electrode, as well as the dielectric constant of the dielectric. The system further includes a reference electrode located no more than 5 cm from the main electrode in the discharge chamber in contact with the plasma when excited. The system further includes a switch for selectively connecting the main electrode or reference electrode to the harmonic generator.

The system further comprises a reference electrode shielding mechanism. This mechanism has two operating positions, where in the first position it exposes the surface of the reference electrode to the plasma and in the second position it hides this surface from the plasma.

Preferably, the reference electrode shielding is designed as a mechanical cover or screen, which hides the reference probe from the influence of the plasma.

Preferably, the reference electrode shielding is designed as a mechanism for moving the reference electrode. For shielding from the plasma, it can therefore move it to a shielded area, for example to an opening in the discharge chamber adapted for insertion of the reference electrode, possibly behind the screen. Alternatively, the reference electrode shielding mechanism may shield the electrode with its base, e.g., after rotation.

Preferably, the operating frequency of the AC voltage provided by the harmonic generator is selected in the range of 0.1-10 MHz.

Description of drawings

The summary of the invention is further explained on the basis of examples of its realization, which are described with the help of accompanying drawings, where:

Figure 1 shows a schematic arrangement of a system for plasma diagnostics.

Figure 2 is an substitute circuit diagram of a system for plasma diagnostics.

Figure 3 is a diagram of the present method of plasma diagnostics.

Figure 4 shows an example of the measured high-frequency voltage $U_{AP}$ and current $I_{AP}$ waveforms on the reference RF probe.

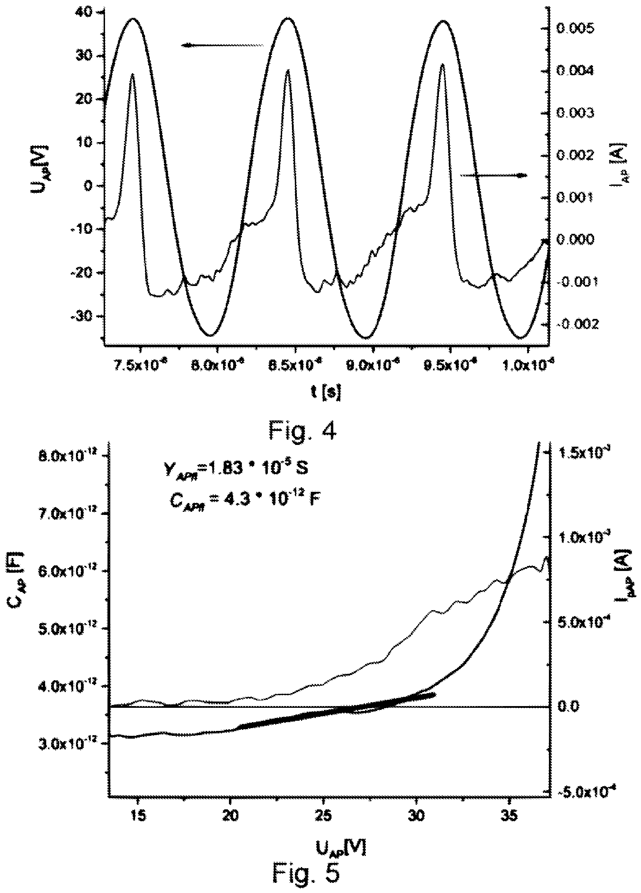

Figure 5 shows an example of determination of the differential conductivity $Y_{AP}$ and the dynamic capacity $C_{AP}$ of the space charge sheath formed at the surface of the reference electrode in the proximity of the floating potential. These parameters are determined from the knowledge of $U_{AP}(t)$ and $I_{AP}(t)$ waveforms. The graph shows the dependence of the current $I_{pAP}$, which is the RF current flowing only by the real admittance $Y_{AP}$, on the voltage $U_{AP}$ and further the dependence of the dynamic capacity of the space charge sheath $C_{AP}$ on the voltage on the probe $U_{AP}$.

Figure 6 shows an example of the measured high frequency voltage $U_{HP}$ and current $I_{HP}$ waveforms on the electrode with a thick dielectric on the main electrode.

Figure 7 shows an example of waveforms of the calculated high-frequency voltage $U_{shHP}$ on the space charge sheath around the surface of main electrode with the thick dielectric and of the high-frequency current $I_{HP}$ flowing through this electrode.

Figure 8 shows the dependence of the determined current $I_{pHP}$, which passes only through the real conductivity $Y_{HP}$, on the voltage $U_{shHP}$ present on the space charge sheath at the surface of the thick dielectric of the main electrode and the dependence of the dynamic capacity of the space charge sheath $C_{HP}$ on the voltage $U_{HP}$.

Examples of Embodiment of the Invention

The invention will be further clarified by means of exemplary embodiments with reference to the respective drawings, which, however, have do not limit scope of protection.

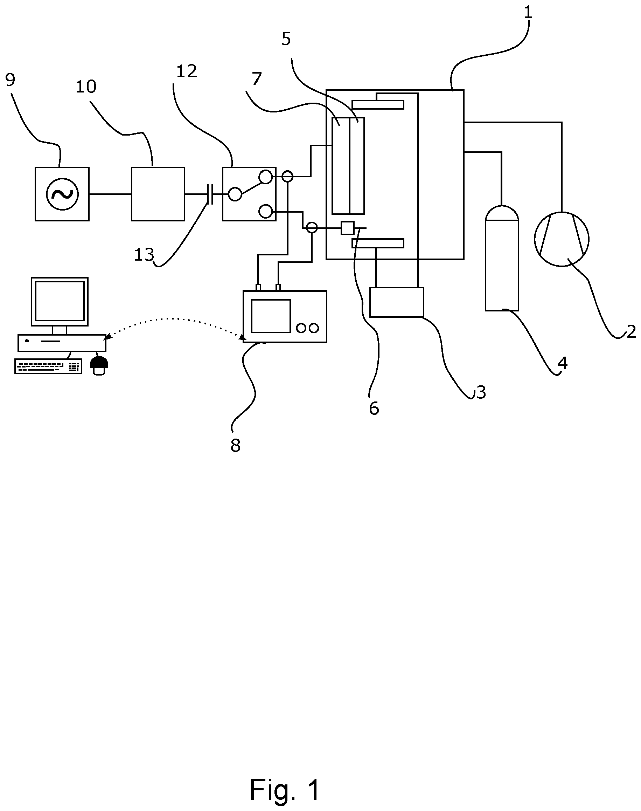

The object of the invention is the system for plasma diagnostics shown in Figure 1 and comprising a discharge chamber 1 and a pump 2 adapted to create and maintain low pressure in the discharge chamber 1, wherein working pressure in the discharge chamber is in the range of atmospheric pressure up to about $10^{-5}$ Pa. However, the range of working pressures does not limit scope of the protection of the invention and choice thereof depends on the specific application. The pump 2 can be any or a combination of the following types of pumps: rotary pump, diaphragm pump, diffusion pump, sorption pump, getter, ionization pump or turbomolecular pump. The discharge chamber 1 further comprises a plasma source 3 adapted to generate plasma in the interior of the discharge chamber 1. The plasma source 3 is selected depending on the desired application for which the plasma is used. The plasma source 3 is, for example, a pair of electrodes of opposite polarities, between which an electric field of sufficient intensity is excited to excite the plasma. The plasma source 3 may further also comprise magnetic elements, such as a coil or a permanent magnet, in order to excite a magnetic field in the proximity of the plasma. The plasma source 3 is controllable, wherein the controllable plasma parameters are, for example, the power of the source, the frequency of the source, etc. For selected applications and use of the described method of plasma diagnostics, it is optimal to choose low-temperature plasma. Another part of the discharge chamber 1 is a working gas reservoir 4, which supplies the working gas or a mixture of working gases to the discharge chamber 1 through a supply system of tubes and valves. The working gas or mixture thereof is selected depending on the application for which the plasma is used. The system for plasma diagnostics further comprises a generator 9 providing an AC voltage with the frequency of the order of 0.01-100 MHz, wherein the AC voltage provided by the generator 9 may have a selectable waveform, e.g., sawtooth, triangular, rectangular, sinusoidal, pulsed, etc., main electrode 7 and reference electrode 6. The main electrode 7 is located in the discharge chamber 1 near the plasma. Due to the repeated use in the discharge chamber 1, the main electrode 7 is covered with a dielectric 5 of unknown composition, roughness and size. The thickness of the dielectric 5 is in the range of 0.1-10 cm. In principle, it is not possible to calculate the area of the dielectric 5, or the area of main electrode 7, on the basis of knowledge of the geometric dimensions of the main electrode 7. A considerable amount of material is deposited on the main electrode 7, or on the dielectric 5, in the discharge chamber 1 during repeated use, e.g., undesirable deposition during PECVD processes, sputtering from the target, etc. Likewise, the surface of the main electrode 7, or the dielectric 5, is bombarded by ions of the plasma, whereby this surface can be etched or sputtered. Both processes are strongly heterogenous, so sputtering, etching and deposition can take place at different speeds at different points on the surface. In addition, oxidation of the surface may occur upon completion of a particular process and exposure of the interior of the discharge chamber 1 to the outside atmosphere. The resulting surface of the main electrode 7 and the dielectric 5 thus has different thicknesses, and in particular an unknown value of the dielectric constant and the capacity $C_d$, which makes it impossible to use it for plasma diagnostics. The reference electrode 6 is located in the discharge chamber 1 near the main electrode 7, or at a distance of 0.1-10 cm. The reference electrode 6 is cylindrical in shape, e.g., in the form of a wire. This form of the reference probe is advantageous because it has easily definable dimensions of diameter and length, but at the same time it has a small effective area with respect to the plasma, and thus the above-mentioned problems of the main electrode 7, i.e. deposition or sputtering, are negligible. The system further contains a matching unit 10 connected to the harmonic generator 9 and adapted to change parameters which affect the main and reference electrodes 6 and 7, in particular, the frequency and magnitude of the voltage provided, and the power supplied to the electrodes. For example, the matching unit 10 is connected to the generator 9 via a blocking capacitor 13 with a capacity $C_V$.

The system further comprises a switch 12, which serves to selectively apply voltage from the matching unit 10 to either the main electrode 7 or the reference electrode 6. Alternatively, two harmonic generators 9 and two matching units 10 can be used, each for one of the electrodes 6, 7. The system further comprises at least one measuring device, for example an oscilloscope 8 or a multimeter 11 is used. The oscilloscope 8 is preferably designed as a two-channel oscilloscope 8. The multimeter 11 serves to measure electrical quantities, especially voltage, current, resistance, capacity, impedance, inductance, etc. for both AC and DC voltage. The oscilloscope 8 and the multimeter 11 serve to monitor the current and voltage waveforms and other electrical parameters on the main probe 7 and the reference probe 6.

The main electrode 7 is provided with a radio frequency current transformer 14 of inductance $L_{rHP}$ and a capacitive voltage meter 15 with a terminating resistor $R_{rvHP}$. From this resistor $R_{rvHP}$, a signal corresponding to the waveform of electrical quantities over time at the main electrode 7 is fed to the oscilloscope 8 or other measuring device. The signal corresponding to the waveform of electrical quantities over time on the current transformer 14 $L_{rHP}$ is applied through a terminating resistor $R_{rHP}$ to the oscilloscope 8 or other measuring device.

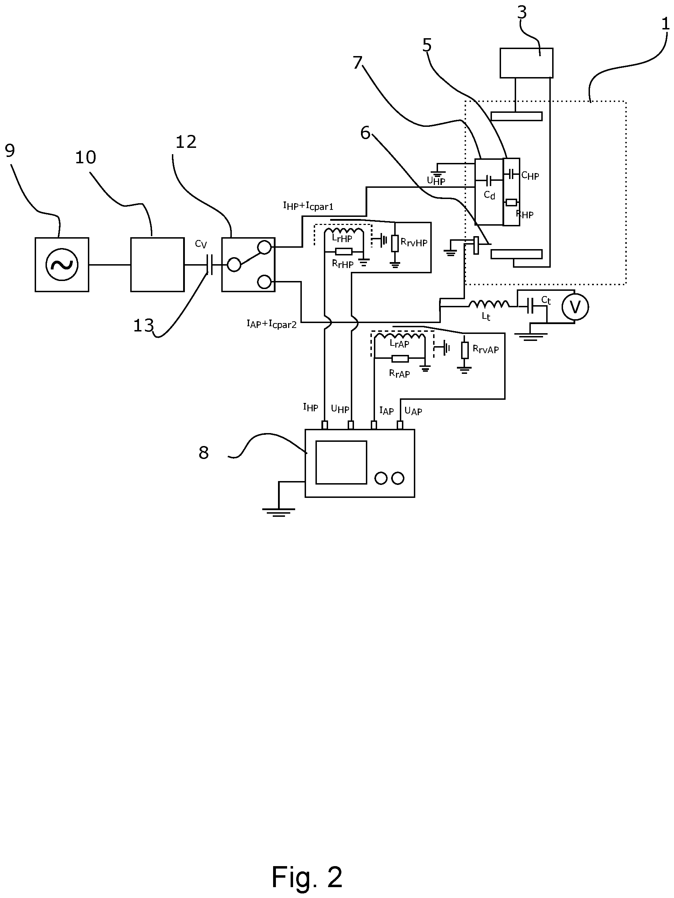

The reference electrode 6 is provided with a radio frequency current transformer 14 of inductance $L_{rAP}$ and a capacitive voltage meter 15 with a terminating resistor $R_{rvAP}$. From this resistor $R_{rvAP}$, a signal corresponding to the waveform of electrical quantities over time at the reference electrode 6 is fed to the oscilloscope 8 or other measuring device. The signal corresponding to the waveform of electrical quantities over time on the current transformer 14 $L_{rAP}$ is applied through a terminating resistor $R_{rAP}$ to the oscilloscope 8 or other measuring device. For direct measurement of the induced DC bias voltage on the reference electrode 6, the radio frequency voltage $U_{AP}$ is fed to the direct voltmeter 11 through a low-pass filter formed by the inductance $L_t$ and the capacitance $Ct$. A substitute electrical diagram of the system is shown in Figure 2.

In the exemplary embodiment, the reference electrode 6 is provided with a reference electrode 6 shielding mechanism. This mechanism serves to cover the reference electrode 6 from the undesired effects of plasma, such as ion bombardment, deposition or electrode etching. Due to the negligibly small effective area of the reference electrode 6 compared to the main electrode 7, the change in $A_{AP}$ area and surface roughness of the reference electrode 6 before and after plasma exposure is not very significant but may affect measurement accuracy in the long run. Service life, i.e., applicability, of the reference electrode 6 is extended by the reference electrode 6 shielding mechanism. After the measurement with the reference electrode 6 is completed, this mechanism is used to cover the reference electrode 6 with, for example, a mechanical screen, a cover. In other exemplary embodiments, the mechanism performs shielding of the reference electrode 6 by moving the reference electrode 6 into the shielded area, e.g.,, it moves it behind the screen, inserts it into the inner area of the discharge chamber 1, or turns it away from the plasma. The reference electrode 6 shielding mechanism can thus be in two positions. In the first position, the reference electrode 6 shielding mechanism allows the surface of the reference electrode 6 to be exposed to the plasma, and in the second position, the reference electrode shielding 6 mechanism covers the electrode from the plasma exposure.

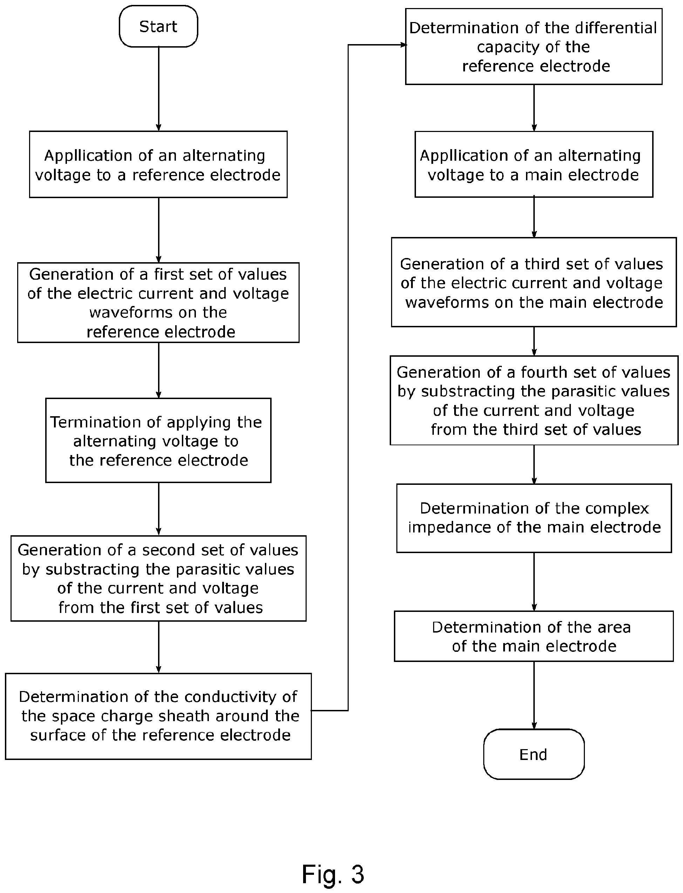

The object of the invention further relates to the method of plasma diagnostics shown in Figure 3, in particular the determination of parameters describing the plasma, such as electron temperature, ion concentration, ion flux on wall sheath and voltage on the wall sheath.

The present method of plasma diagnostics requires knowledge of the parasitic capacitive currents $I_{cpar1}$ and $I_{cpar2}$ passing through the electrode holders 6, 7 to the ground and thus not flowing into the plasma. The values of the parasitic capacitive currents $I_{cpar1}$ are measured by applying an alternating voltage from the generator 9 to the main electrode 7 and obtaining a volt-ampere characteristic. The values of the parasitic capacitive currents $I_{cpar2}$ are measured by applying an alternating voltage from the generator 9 to the reference electrode 6 and obtaining a volt-ampere characteristic.

The present method of plasma diagnostics is performed with the excited plasma in the discharge chamber 1 and comprises at least the following steps:

- application of an alternating voltage provided by the harmonic generator 9 through the switch 12 to the reference electrode 6, which is located in the discharge chamber 1 with the excited plasma.

- generation of a first set of values of the waveforms of the electric current and voltage on the reference electrode 6. This step corresponds to the measurement of the volt-ampere characteristic. The data are read by a voltmeter 11, a voltage meter 15 or an oscilloscope 8. For example, these data are stored either in a memory unit of a given measuring device, a cloud or in a computer storage with which the measuring device can be communicatively connected. The data of the first set of values can also reflect the time dependence of the measured values.

- - generation of a second set of values of the waveforms of the electric current and voltage on the reference electrode 6 by subtracting the parasitic values of the current $I_{cpar2}$ and the voltage of the reference electrode 6 from the first set of values. This gives data that correspond to the measured values of the reference electrode 6 in the plasma. The time dependence of the waveforms of the high-frequency voltage $U_{AP}$ and the $I_{AP}$ current on the reference electrode 6 after subtracting the parasitic capacitive current $I_{cpar2}$ in the presence of the low-temperature plasma generated by the plasma source 3 is shown in Figure 4.

- determination of the differential conductivity $Y_{AP}$ of the space charge sheath around the surface of the reference electrode 6 and the differential capacity $C_{AP}$ of the reference electrode. These values are obtained from the second set of values for values close to the value of the floating potential of the plasma just excited in the discharge chamber 1.

In practice, this step is performed by calculation from the knowledge of waveform of $U_{AP}$ voltage on the reference electrode 6 and of current $I_{AP}$ flowing through the reference electrode 6. From these values the dependence of current $I_{PAP}$ on voltage $U_{AP}$ is determined, where the monitored current flows only by real conductivity $Y_{AP}$ without capacitive current which flows through capacity $C_{AP}$ only. From this dependence, it is possible to determine the differential conductivity $Y_{AP}$ by calculating the trend tangent in the floating potential $U_{fl}$ region, when for a given voltage at the reference electrode the current of electrons and ions incident on it is balanced and the total current flowing is zero.

This dependence and the described calculation are shown in Figure 5.

The present method of plasma diagnostics comprises, in contrast to the prior art, the following steps: application of an alternating voltage of frequency $f$ to the main electrode 7 located in the plasma discharge chamber 1. This step is performed, for example, by switching the switch 12. The supply of alternating voltage to the main electrode 7 thus takes place after the supply of alternating voltage to the reference electrode 6 is completed.

- generation of a third set of values of waveforms of electric current and voltage on the main electrode 7. This step corresponds to the measurement of the volt-ampere characteristic. The data are read by a voltmeter 11, a voltage meter 15 or an oscilloscope 8. For example, these data are stored either in a memory unit of a given measuring device, a cloud or in a computer storage with which the measuring device can be communicatively connected. The data of the first set of values can also reflect the time dependence of the measured values.

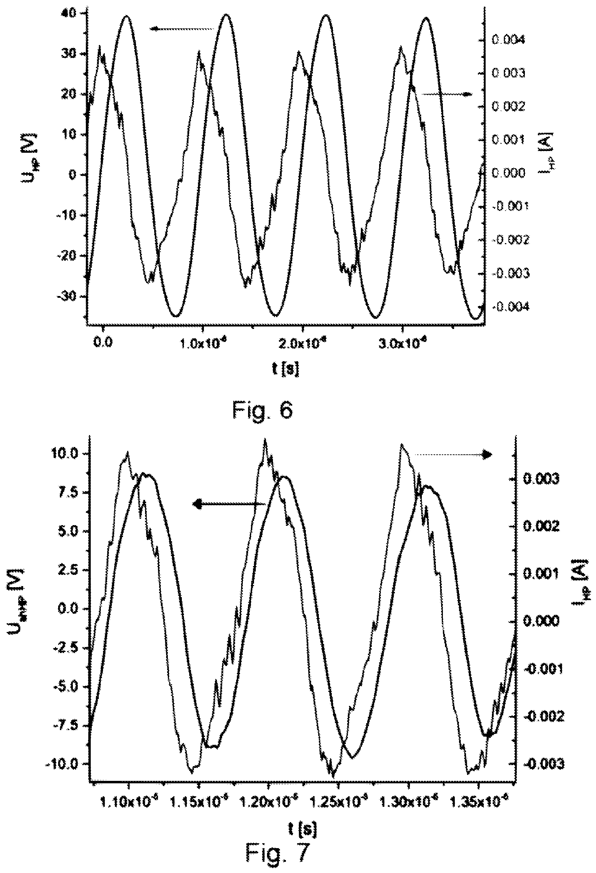

- generation of a fourth set of values of the waveforms of the electric current and voltage on the main electrode 7 by subtracting the parasitic values of the current $I_{cpar1}$ and the voltage of the main electrode 7 from the third set of values. This gives data which correspond to the measured values of the main electrode 7 in the plasma. The time dependence of the waveforms of the high-frequency voltage $U_{HP}$ and current $I_{HP}$ on the main electrode 7 after subtracting the parasitic capacitive current $I_{cpar1}$ in the presence of the low-temperature plasma generated by the plasma source 3 are shown in Figure 6.

- determination of the complex impedance of the $Z_{HP}$ of the main electrode 7 from the fourth set of values.

The complex impedance is generally calculated according to the following relation:

$$\hat{Z}_{HP} = \frac{\hat{U}_{HP}}{\hat{I}_{HP}}.$$

For the calculation, the optimal harmonic component from the measured signals is the fundamental harmonic frequency corresponding to the frequency supplied by the harmonic generator 9.

The following equation applies to the complex impedance:

$$Z_{HP} = \frac{-j}{\omega C_d} + \frac{1}{k \cdot Y_{AP} + j\omega k C_{AP}},$$

where $j$ is a complex unit, $\omega = 2\pi f$ is the angular frequency of the voltage provided by the harmonic generator and the coefficient $k = A_{HP} / A_{AP}$ is the ratio of the areas of the main electrode 7 and the reference electrode 6.

The complex impedance can be divided into real and imaginary components, where the following equations apply to the partial components:

$$\mathrm{Re}Z_{HP} = \frac{Y_{AP}}{k \cdot (Y_{AP}^2 + \omega^2 C_{AP}^2)}$$

and

$$\mathrm{Im}Z_{HP} = \frac{-1}{\omega C_d} - \frac{\omega C_{AP}}{k(Y_{AP}^2 + \omega^2 C_{AP}^2)}$$

For the conductivities obtained for the main and reference electrodes $7$, $6$ it follows that they are proportional to the ratio of the areas of these electrodes $7$, $6$, or $Y_{HP} = k * Y_{AP}$ and $C_{HP} = k * C_{AP}$.

- calculating the area of the main electrode $7$ using the relation

$$k = \frac{Y_{AP}}{\mathrm{Re}Z_{HP}((Y_{AP}^2 + \omega^2 C_{AP}^2)}.$$

By further calculation it is possible to determine the capacity of the dielectric $5$ as follows:

$$C_d = \frac{-1}{\omega(\mathrm{Im}Z_{HP} + \frac{\omega C_{AP}}{k(Y_{AP}^2 + \omega^2 C_{AP}^2)})}.$$

From the measured time dependence of the current $I_{HP}$ flowing through the main electrode $7$ and thanks to the knowledge of the capacity of the dielectric $5$, it is possible to determine the voltage on the dielectric $5$ by the relation

$$U_{cd} = \frac{1}{C_d} \int_0^t i_{HP} dt$$

and subsequently the voltage on the wall sheath of the plasma by the relation

$$U_{shHP} = U_{HP} - U_{cd}.$$

Figure 7 then shows the dependence of the waveform of the high-frequency voltage $U_{shHP}(t)$ on the space charge sheath around the surface of the main electrode $7$ with the thick dielectric $5$ and the high-frequency current $I_{HP}(t)$ flowing through this electrode.

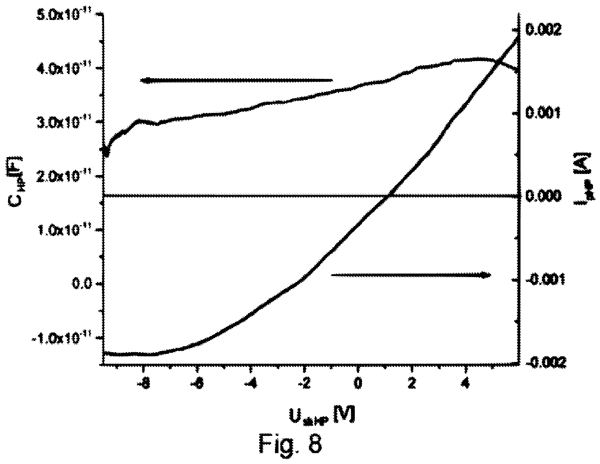

In Figure 8, there is the dependence of the determined current $I_{pHP}$ passing through only the real conductivity $Y_{HP}$ on the voltage $U_{shHP}$ present on the space charge sheath at the surface of the thick dielectric $5$ of the main electrode $7$ and the dependence of the dynamic capacity of the space charge sheath $C_{HP}$ on the voltage $U_{shHP}$.

From the knowledge of the measured waveform of $I_{HP}$, the waveform of the RF voltage $U_{cd}(t)$ was determined from relation (1) and then, according to relation (2), the waveform of the voltage on the space charge sheath at the HP electrode $U_{shHP}(t)$ was determined. In Figure 7, there is an example of the searched waveforms of the calculated high-frequency voltage.

This information can be used to describe the physical processes around the HP electrode. In Figure 8, there is the dependence of the determined current $I_{pHP}$ passing through only the real conductivity $Y_{HP}$ on the voltage $U_{shHP}$ present on the space charge sheath at the surface of the thick dielectric of the electrode HP and the dependence of the dynamic capacity of the space charge sheath $C_{HP}$ on the voltage $U_{shHP}$.

The dependence of $I_{pHP}(U_{shHP})$ can be used to determine the saturated ion flux to the surface of the thick dielectric of the HP electrode and other plasma parameters such as $T_e$ and $n_i$. The magnitude of the amplitude of the RF voltage $U_{shHP}$ determines, according to the relation (u1), the magnitude of the DC bias induced on the spatial charge sheath at the surface of the dielectric HP, which determines the energy of positive ions bombarding the dielectric surface.

Industrial applicability

Diagnostics of reactive processes in plasma on the dielectric surface, plasma surface treatment and deposition of thin films using high-frequency voltages on dielectric substrates, plasma etching, diagnostics of low-temperature plasma.

List of reference marks

1- discharge chamber
2 - pump
3 - plasma source
4 - working gas tank
5 - dielectric
6 - reference electrode
7 - main electrode
8 - oscilloscope
9 - harmonic RF generator
10 - matching unit
11 - voltmeter
12 - switch
13 - blocking capacitor
14 - current transformer $L_{rHP}$
15 - voltmeter

**Claims**

1. A method of plasma diagnostics comprising the steps of:

   - application of an alternating voltage of frequency $f$ to a reference electrode (6) of measurable area $A_{AP}$ located in a plasma discharge chamber (1);
   - generation of a first set of values of the electric current and voltage waveforms on the reference electrode (6);
   - termination of applying the alternating voltage to the reference electrode (6);
   - generation of a second set of values of the of the electric current and voltage waveforms on the reference electrode (6) by subtracting the parasitic values of the current and voltage of the reference electrode (6) from the first set of values;
   - and determination of the differential conductivity $Y_{AP}$ of the space charge sheath around the surface of the reference electrode (6) and the differential capacity $C_{AP}$ of the reference electrode (6), wherein these quantities are calculated from the second set of values for the values close to the floating potential of the plasma excited in the discharge chamber (1),

   wherein the method further comprises the steps:

   - application of an alternating voltage of frequency $f$ to a dielectric-covered main electrode (7) placed in the plasma discharge chamber (1), wherein the area of the main electrode (7) $A_{HP}$ is unknown;
   - wherein the value of the frequency $f$ is the same value as the frequency $f$ of the alternating voltage applied to the reference electrode (6) and is in the range 0.01-100 MHz.
   - generation of a third set of values of the electric current and voltage waveforms on the main electrode (7);
   - generation of a fourth set of values of the electric current and voltage waveforms on the main electrode (7) by subtracting the parasitic values of the current and voltage of the main electrode (7) from the third set of values;
   - determination of the complex impedance $Z_{HP}$ of the main electrode (7) from the fourth set of values
   - and calculation of the area of the main electrode (7) $A_{HP}$ using the relation

$$k = \frac{Y_{AP}}{\mathrm{Re} Z_{HP}((Y_{AP}^2 + \omega^2 C_{AP}^2)},$$

where the coefficient *k* corresponds to the ratio of the areas of the main electrode (7) and the reference electrode (6) and $\omega$ is the angular frequency of the voltage.

2. The method of plasma diagnostics according to claim 1, wherein the capacitance of the dielectric (5) $C_d$ covering the main electrode (7) is further calculated using the relation

$$C_d = \frac{-1}{\omega(\mathrm{Im}Z_{HP} + \frac{\omega C_{AP}}{k(Y_{AP}^2 + \omega^2 C_{AP}^2)})}.$$

3. The method of plasma diagnostics according to any one of claims 1 to 2, wherein the value of the frequency *f* is in the range 0.1-10 MHz.

4. The method of plasma diagnostics according to any one of claims 1 to 3, wherein the frequency f is lower than the plasma frequency of the ions.

5. The method of plasma diagnostics according to any one of claims 1 to 4, wherein the parasitic values of current and voltage of the reference electrode (6) are obtained by applying an alternating voltage of frequency *f* to the reference electrode (6) and parasitic values of current and voltage of the main electrode (7) are obtained by applying an alternating voltage of frequency f to the main electrode (7), wherein the measurements are carried out in the absence of plasma.

6. The method of plasma diagnostics according to any one of claims 1 to 5, wherein the values of at least one of the following plasma parameters are further determined: electron temperature, ion concentration, ion flux to the dielectric surface and voltage on the wall sheath.

7. The method of plasma diagnostics according to any one of claims 1 to 6, wherein after termination of the termination step of applying the alternating voltage to the reference electrode (6), the reference electrode (6) is covered by a reference electrode (6) shielding mechanism.

8. A system for plasma diagnostics comprising a discharge chamber (1), a pump (2) designed to maintain a low pressure in the discharge chamber (1), a plasma source (3), a harmonic generator (9) and at least one measuring device (8, 11) adapted to monitor values of voltage and current on a selected electrical circuit component, wherein the system further comprises a dielectric (5) covered main electrode (7) of unknown area and surface roughness located in the discharge chamber (1), a reference electrode (6) located at most 5 cm from the main electrode (7) in the discharge chamber (1), a switch (12) for selectively connecting the main electrode (7) or the reference electrode (6) to the harmonic generator (9) and a reference electrode (6) shielding mechanism, wherein the mechanism has two operating positions, and wherein the mechanism is configured such that, in the case that it is in the first operating position, it allows the surface of the reference electrode (6) to be exposed to the plasma, and in the case that it is in the second operating position, it hides the surface of the reference electrode (6) from the plasma.

9. The system for plasma diagnostics according to claim 8, wherein the reference electrode (6) shielding mechanism is designed as a mechanical cover or screen.

10. The system for plasma diagnostics according to claim 8, wherein the reference electrode (6) shielding mechanism is designed as a mechanism for moving the reference electrode (6).

11. The system for plasma diagnostics according to any one of claims 8 to 10, wherein the harmonic generator (9) provides an alternating voltage with frequency values in the range 0.1-10 MHz.

**Patentansprüche**

1. Ein Verfahren zur Plasmadiagnostik, umfassend die folgenden Schritte:

   - das Anlegen einer Wechselspannung der Frequenz f an eine sich in einer Plasmaentladungskammer (1) befindliche Referenzelektrode (6) einer messbaren Fläche $A_{AP}$;

- das Erzeugen eines ersten Wertesatzes der elektrischen Strom- und Spannungswellenformen auf der Referenzelektrode (6);
- das Beenden des Anlegens der Wechselspannung an die Referenzelektrode (6);
- das Erzeugen eines zweiten Wertesatzes der elektrischen Strom- und Spannungswellenformen auf der Referenzelektrode (6) durch Subtrahieren der parasitären Werte des Stroms und der Spannung der Referenzelektrode (6) vom ersten Wertesatz;
- und das Bestimmen der Differenzleitfähigkeit $Y_{AP}$ der Raumladungsschicht um die Oberfläche der Referenzelektrode (6) und der Differenzkapazität $C_{AP}$ der Referenzelektrode (6), wobei diese Größen aus dem zweiten Wertesatz für die Werte nahe dem Schwebepotential des in der Entladungskammer (1) angeregten Plasmas berechnet werden,

wobei das Verfahren ferner die folgenden Schritte umfasst:

- das Anlegen einer Wechselspannung der Frequenz f an eine in der Plasmaentladungskammer (1) angeordnete, mit einem Dielektrikum bedeckte Hauptelektrode (7), wobei die Fläche der Hauptelektrode (7) $A_{HP}$ unbekannt ist;
- wobei der Wert der Frequenz f derselbe Wert ist wie die Frequenz f der an die Referenzelektrode (6) angelegten Wechselspannung und im Bereich von 0,01-100 MHz liegt.
- das Erzeugen eines dritten Wertesatzes der elektrischen Strom- und Spannungswellenformen auf der Hauptelektrode (7);
- das Erzeugen eines vierten Wertesatzes der elektrischen Strom- und Spannungswellenformen auf der Hauptelektrode (7) durch Subtrahieren der parasitären Werte des Stroms und der Spannung der Hauptelektrode (7) vom dritten Wertesatz;
- das Bestimmen der komplexen Impedanz $Z_{HP}$ der Hauptelektrode (7) aus dem vierten Wertesatz;
- und das Berechnen der Fläche der Hauptelektrode (7) $A_{HP}$ unter Verwendung der Beziehung

$$k = \frac{Y_{AP}}{\mathrm{Re} Z_{HP}((Y_{AP}^2 + \omega^2 C_{AP}^2)},$$

wo der Koeffizient k dem Verhältnis der Flächen der Hauptelektrode (7) und der Referenzelektrode (6) entspricht und $\omega$ die Winkelfrequenz der Spannung ist.

2. Das Verfahren zur Plasmadiagnostik nach Anspruch 1, wobei die Kapazität des Dielektrikums (5) $C_d$, das die Hauptelektrode (7) bedeckt, ferner unter Verwendung der folgenden Beziehung berechnet wird

$$C_d = \frac{-1}{\omega(\mathrm{Im} Z_{HP} + \frac{\omega C_{AP}}{k(Y_{AP}^2 + \omega^2 C_{AP}^2)})}.$$

3. Das Verfahren zur Plasmadiagnostik nach einem der Ansprüche 1 bis 2, wobei der Wert der Frequenz f im Bereich von 0,1-10 MHz liegt.

4. Das Verfahren zur Plasmadiagnostik nach einem der Ansprüche 1 bis 3, wobei die Frequenz f niedriger ist als die Plasmafrequenz der Ionen.

5. Das Verfahren der Plasmadiagnostik nach einem der Ansprüche 1 bis 4, wobei die parasitären Werte des Stroms und der Spannung der Referenzelektrode (6) durch Anlegen einer Wechselspannung der Frequenz f an die Referenzelektrode (6) erhalten werden und die parasitäre Werte des Stroms und der Spannung der Hauptelektrode (7) durch Anlegen einer Wechselspannung der Frequenz f an die Hauptelektrode (7) erhalten werden, wobei die Messungen in Abwesenheit von Plasma durchgeführt werden.

6. Das Verfahren zur Plasmadiagnostik nach einem der Ansprüche 1 bis 5, wobei die Werte mindestens eines der folgenden Plasmaparameter ferner bestimmt werden: Elektronentemperatur, Ionenkonzentration, Ionenfluss zur dielektrischen Oberfläche und Spannung auf der Wandschicht.

7. Das Verfahren zur Plasmadiagnostik nach einem der Ansprüche 1 bis 6, wobei nach dem Beenden des Beendigungsschrittes des Anlegens der Wechselspannung an die Referenzelektrode (6) die Referenzelektrode (6) von einem Referenzelektrode-Abschirmmechanismus abgedeckt wird.

# EP 4 416 753 B1

**8.** Ein System zur Plasmadiagnostik, umfassend eine Entladungskammer (1), eine Pumpe (2), die dazu eingerichtet ist, einen niedrigen Druck in der Entladungskammer (1) aufrechtzuerhalten, eine Plasmaquelle (3), einen harmonischen Generator (9) und mindestens eine Messvorrichtung (8, 11), die dafür ausgelegt ist, die Spannungs- und Stromwerte auf einer ausgewählten elektrischen Schaltungskomponente zu überwachen, wobei das System ferner eine mit einem Dielektrikum (5) bedeckte Hauptelektrode (7) mit unbekannter Oberfläche und Oberflächenrauheit, die in der Entladungskammer (1) angeordnet ist, eine Referenzelektrode (6), die höchstens 5 cm von der Hauptelektrode (7) entfernt in der Entladungskammer (1) angeordnet ist, einen Schalter (12) zum selektiven Verbinden der Hauptelektrode (7) oder der Referenzelektrode (6) mit dem harmonischen Generator (9) und einen Referenzelektrode-Abschirmmechanismus umfasst, wobei der Mechanismus zwei Betriebspositionen aufweist, und wobei der Mechanismus derart ausgebildet ist, dass er in der ersten Betriebsposition das Aussetzen der Oberfläche der Referenzelektrode (6) dem Plasma erlaubt, und dass er in der zweiten Betriebsposition die Oberfläche der Referenzelektrode (6) vor dem Plasma verbirgt.

**9.** Das System zur Plasmadiagnostik nach Anspruch 8, wobei der Referenzelektrode-Abschirmmechanismus als mechanische Abdeckung oder Blende ausgebildet ist.

**10.** Das System zur Plasmadiagnostik nach Anspruch 8, wobei der Referenzelektrode-Abschirmmechanismus als ein Mechanismus zum Bewegen der Referenzelektrode (6) ausgebildet ist.

**11.** Das System zur Plasmadiagnostik nach einem der Ansprüche 8 bis 10, wobei der harmonische Generator (9) eine Wechselspannung mit Frequenzwerten im Bereich von 0,1-10 MHz bereitstellt.

## Revendications

**1.** Une méthode de diagnostic d'un plasma, comprenant les étapes consistant à :

- une application d'une tension alternative de fréquence f à une électrode de référence (6) de superficie mesurable $A_{AP}$, disposée dans une chambre de décharge de plasma (1) ;
- une génération d'un premier ensemble de valeurs des formes d'onde de courant électrique et de tension sur l'électrode de référence (6) ;
- une cessation d'application de la tension alternative à l'électrode de référence (6) ;
- une génération d'un deuxième ensemble de valeurs des formes d'onde de courant électrique et de tension sur l'électrode de référence (6) par soustraction des valeurs parasites du courant et de la tension de l'électrode de référence (6) du premier ensemble de valeurs ;
- et une détermination de la conductivité différentielle $Y_{AP}$ de la couche de charge spatiale autour de la surface de l'électrode de référence (6) et de la capacité différentielle $C_{AP}$ de l'électrode de référence (6), où ces quantités sont calculées à partir du deuxième ensemble de valeurs pour les valeurs proches du potentiel flottant du plasma excité dans la chambre de décharge (1),

où la méthode comprend en outre les étapes consistant à :

- une application d'une tension alternative de fréquence f à une électrode principale recouverte de diélectrique (7), disposée dans la chambre de décharge de plasma (1), où la superficie de l'électrode principale (7) $A_{HP}$ est inconnue ;
- où la valeur de la fréquence f est la même valeur que la fréquence f de la tension alternative appliquée à l'électrode de référence (6) et est dans la plage de 0,01-100 MHz ;
- une génération d'un troisième ensemble de valeurs des formes d'onde de courant électrique et de tension sur l'électrode principale (7) ;
- une génération d'un quatrième ensemble de valeurs des formes d'onde de courant et de tension électrique sur l'électrode principale (7) par soustraction des valeurs parasites du courant et de la tension de l'électrode principale (7) du troisième ensemble de valeurs ;
- une détermination de l'impédance complexe $Z_{HP}$ de l'électrode principale (7) à partir du quatrième ensemble de valeurs ;
- et un calcul de la superficie de l'électrode principale (7) $A_{HP}$ à l'aide de la relation

$$k = \frac{Y_{AP}}{\mathrm{Re}Z_{HP}((Y_{AP}^2 + \omega^2 C_{AP}^2))},$$

où le coefficient $k$ correspond au rapport des superficies de l'électrode principale (7) et de l'électrode de référence (6) et $\omega$ est la fréquence angulaire de la tension.

2. La méthode de diagnostic d'un plasma selon la revendication 1, où la capacité du diélectrique (5) $C_d$ recouvrant l'électrode principale (7) est en outre calculée à l'aide de la relation

$$C_d = \frac{-1}{\omega(\mathrm{Im}Z_{HP} + \frac{\omega C_{AP}}{k(Y_{AP}^2 + \omega^2 C_{AP}^2)})}.$$

3. La méthode de diagnostic d'un plasma selon l'une quelconque des revendications 1 à 2, où la valeur de la fréquence $f$ est dans la plage de 0,1-10 MHz.

4. La méthode de diagnostic d'un plasma selon l'une quelconque des revendications 1 à 3, où la fréquence f est inférieure à la fréquence plasma des ions.

5. La méthode de diagnostic d'un plasma selon l'une quelconque des revendications 1 à 4, où les valeurs parasites de courant et de tension de l'électrode de référence (6) sont obtenues par application d'une tension alternative de fréquence $f$ à l'électrode de référence (6) et des valeurs parasites de courant et de tension de l'électrode principale (7) sont obtenues par application d'une tension alternative de fréquence $f$ à l'électrode principale (7), où les mesures sont effectuées en l'absence de plasma.

6. La méthode de diagnostic d'un plasma selon l'une quelconque des revendications 1 à 5, où les valeurs d'au moins un des paramètres de plasma suivants sont en outre déterminées : la température d'électrons, la concentration d'ions, le flux d'ions vers la surface diélectrique et la tension sur la couche de paroi.

7. La méthode de diagnostic d'un plasma selon l'une quelconque des revendications 1 à 6, où, après avoir terminé l'étape de cessation consistant à appliquer la tension alternative à l'électrode de référence (6), l'électrode de référence (6) est recouverte par un mécanisme de blindage d'électrode de référence (6).

8. Un système de diagnostic d'un plasma, comprenant une chambre de décharge (1), une pompe (2) conçue pour maintenir une basse pression dans la chambre de décharge (1), une source de plasma (3), un générateur d'harmoniques (9), et au moins un dispositif de mesure (8, 11) conçu pour surveiller des valeurs de tension et de courant sur un composant de circuit électrique sélectionné, où le système comprend en outre une électrode principale recouverte de diélectrique (5) de superficie et de rugosité de surface inconnue, disposée dans la chambre de décharge (1), une électrode de référence (6) disposée au plus à 5 cm de l'électrode principale (7) dans la chambre de décharge (1), un commutateur (12) pour connecter sélectivement l'électrode principale (7) ou l'électrode de référence (6) au générateur d'harmoniques (9), et un mécanisme de blindage d'électrode de référence (6), où le mécanisme a deux positions de fonctionnement, et où le mécanisme est configuré de telle sorte que, dans le cas où il est dans la première position de fonctionnement, il permet à la surface de l'électrode de référence (6) d'être exposée au plasma, et dans le cas où il est dans la seconde position de fonctionnement, il cache la surface de l'électrode de référence (6) à partir du plasma.

9. Le système de diagnostic d'un plasma selon la revendication 8, où le mécanisme de blindage d'électrode de référence (6) est conçu sous la forme d'un capot mécanique ou d'un écran.

10. Le système de diagnostic d'un plasma selon la revendication 8, où le mécanisme de blindage d'électrode de référence (6) est conçu sous la forme d'un mécanisme pour déplacer l'électrode de référence (6).

11. Le système de diagnostic d'un plasma selon l'une quelconque des revendications 8 à 10, où le générateur d'harmoniques (9) fournit une tension alternative avec des valeurs de fréquence dans la plage de 0,1-10 MHz.

Fig. 1

Fig. 2

```
                   ┌──────────┐                    ┌─────────────────────────────┐
                   │  Start   │                    │ Determination of the differential│
                   └────┬─────┘                    │      capacity of the        │
                        │                           │      reference electrode     │
                        │                           └──────────────┬──────────────┘
                        │                                          │
             ┌──────────▼───────────┐              ┌───────────────▼─────────────┐
             │ Appllication of an   │              │  Appllication of an          │
             │ alternating voltage  │              │  alternating voltage         │
             │ to a reference       │              │  to a main electrode         │
             │ electrode            │              └───────────────┬─────────────┘
             └──────────┬───────────┘                             │
                        │                           ┌──────────────▼──────────────┐
             ┌──────────▼───────────┐              │  Generation of a third set   │
             │ Generation of a first│              │  of values of the electric   │
             │ set of values of the │              │  current and voltage         │
             │ electric current and │              │  waveforms on the main       │
             │ voltage waveforms on │              │  electrode                   │
             │ the reference        │              └──────────────┬──────────────┘
             │ electrode            │                             │
             └──────────┬───────────┘              ┌──────────────▼──────────────┐
                        │                           │ Generation of a fourth set   │
             ┌──────────▼───────────┐              │ of values by substracting    │
             │ Termination of       │              │ the parasitic values of the  │
             │ applying the         │              │ current and voltage from the │
             │ alternating voltage  │              │ third set of values          │
             │ to the reference     │              └──────────────┬──────────────┘
             │ electrode            │                             │
             └──────────┬───────────┘              ┌──────────────▼──────────────┐
                        │                           │ Determination of the complex │
             ┌──────────▼───────────┐              │ impedance of the main        │
             │ Generation of a      │              │ electrode                    │
             │ second set of values │              └──────────────┬──────────────┘
             │ by substracting the  │                             │
             │ parasitic values of  │              ┌──────────────▼──────────────┐
             │ the current and      │              │ Determination of the area    │
             │ voltage from the     │              │ of the main electrode        │
             │ first set of values  │              └──────────────┬──────────────┘
             └──────────┬───────────┘                             │
                        │                               ┌──────────▼─────────┐
             ┌──────────▼───────────┐                  │       End          │
             │ Determination of the │                  └────────────────────┘
             │ conductivity of the  │
             │ space charge sheath  │
             │ around the surface of│
             │ the reference        │
             │ electrode            │
             └──────────────────────┘
```

# Fig. 3

Fig. 4

$Y_{APff} = 1.83 * 10^{-5} S$

$C_{APff} = 4.3 * 10^{-12} F$

Fig. 5

Fig. 6

Fig. 7

Fig. 8

## REFERENCES CITED IN THE DESCRIPTION

**Patent documents cited in the description**

- US 3860507 A
- US 3369991 A

- CZ 31194 U1

**Non-patent literature cited in the description**

- **M.A. LIBERMAN** ; **A.J. LICHTENBERG**. Principles of Plasma Discharges and Materials Processing. Wiley, 1994
- **MARK A. SOBOLEWSKI**. Monitoring sheath voltages and ion energies in high-density plasmas using noninvasive radio-frequency current and voltage measurements. *Journal of Applied Physics*, 2004, vol. 95, 4593
- **J. L. VOSSEN**. *RF SPUTTERING APPARATUS AND METHOD*
- **D.L. FLAMM**. *Solid State Technol.*, 1991, vol. 34, 47
- **MARK A. SOBOLEWSKI,**. Measuring the ion current in high-density plasmas using radio-frequency current and voltage measurements. *Journal of Applied Physics*, 2001, vol. 90, 2660

- **MARK A. SOBOLEWSKI**. Experimental test of models of high-plasma-density, radio-frequency sheaths,. *PHYSICAL REVIEW E*, 1999, vol. 59, 1059-1072
- **P. SEZEMSKY** ; **V. STRANAK** ; **J. KRATOCHVIL** ; **M. CADA** ; **R. HIPPLER** ; **M. HRABOVSKY** ; **Z. HUBICKA**. Modified high frequency probe approach for diagnostics of highly reactive plasma. *Plasma Sources Sci. Technol.*, 2019, vol. 28 (115009), 10
- **LUNDIN DANIEL et al.** Time-resolved ion flux and impedance measurements for process characterization in reactive high-power impulse magnetron sputtering. *JOURNAL OF VACUUM SCIENCE*, 06 June 2016, vol. 34 (4)